# EUROPEAN PATENT APPLICATION

(11) **EP 3 389 100 A1**
(43) Date of publication of application: **17.10.2018**
(21) Application number: 16872631.3
(22) Date of filing: 09.12.2016
(51) Int. Cl.: H01L 33/50, C09K 11/02, C09K 11/08, G02B 5/20, H01S 5/022

(54) **WAVELENGTH CONVERTER, WAVELENGTH CONVERSION MEMBER, AND LIGHT-EMITTING DEVICE**

(30) Priority: 11.12.2015 JP 2015242020
(71) Applicant: Panasonic Intellectual Property Management Co., Ltd., Osaka-shi, Osaka 540-6207 (JP)
(72) Inventor: OKUNO, Tatsuya, Osaka-shi, Osaka 540-6207 (JP); NAKAMURA, Masahiro, Osaka-shi, Osaka 540-6207 (JP); LEE, Youshin, Osaka-shi, Osaka 540-6207 (JP); FUJII, Shunpei, Osaka-shi, Osaka 540-6207 (JP)
(74) Representative: Müller-Boré & Partner Patentanwälte PartG mbB
(86) International application number: PCT/JP2016/005090
(87) International publication number: WO 2017/098730

(57) **Abstract**

A wavelength converter includes: a plurality of phosphor particles; and a binder layer that adheres the plurality of adjacent phosphor particles to one another, the binder layer being composed of a nanoparticle-adhered body in which a plurality of nanoparticles having an average particle size D₅₀ of 1 nm or more and less than 100 nm are adhered to one another.

## Description

### TECHNICAL FIELD

The present invention relates to a wavelength converter using photoluminescence, and particularly, relates to a wavelength converter excellent in heat resistance and heat dissipation even when irradiated with high-power excitation light and excellent in productivity, and to a wavelength conversion member and a light emitting device.

### BACKGROUND ART

Heretofore, as a wavelength converter using photoluminescence, there has been known a wavelength converter composed of: a plurality of phosphor particles which emit light by being irradiated with excitation light; and a binder that holds the plurality of phosphor particles. Specifically, a wavelength converter in which silicon resin is filled with a phosphor has been known. For example, the wavelength converter has such a form as a plate-shaped body and a layered body formed on a metal oxide and a metal substrate.

In recent years, the wavelength converter has been required to increase power of excitation light in order to enhance a light output. Therefore, for the wavelength converter, high-power excitation light of a laser light source or the like has been being used as the excitation light. However, an organic binder such as silicon resin is poor in heat resistance and heat dissipation. Therefore, when the wavelength converter having the organic binder is irradiated with the high-power excitation light of the laser light source or the like, an organic substance that composes the binder is discolored and burnt to decrease light transmittance of the wavelength converter, whereby light output efficiency of the wavelength converter is prone to decrease. Moreover, when the wavelength converter having the organic binder is irradiated with the high-power excitation light of the laser light source or the like, the wavelength converter generates heat since thermal conductivity of the organic substance is usually as low as less than 1 W/m·K. As a result, the wavelength converter having the organic binder is prone to cause temperature quenching of the phosphor.

### CITATION LIST

### PATENT LITERATURE

Patent Literature 1: Japanese Patent No. 5090549
Patent Literature 2: Japanese Unexamined Patent Application Publication No. 2015-38960

### SUMMARY OF INVENTION

### TECHNICAL PROBLEM

For the above, Patent Literature 1 discloses a wavelength converter obtained by using and sintering a ceramic material, which has high heat resistance, heat dissipation and visible light transmittance, an organic binder such as silicon resin, and a phosphor. The wavelength converter of Patent Literature 1 is manufactured by performing the sintering, for example, at a temperature as high as approximately 1200°C. However, the wavelength converter of Patent Literature 1 has had a problem of low productivity due to the sintering at such a high temperature. Moreover, in the CASN ((Sr,Ca)AlSiN₃:Eu) phosphor that is a phosphor excellent in color rendering and widely used as a phosphor for a white LED, an oxidation reaction occurs under a high-temperature environment, and a luminance maintenance rate is prone to significantly decrease. Therefore, the wavelength converter of Patent Literature 1, which is subjected to the sintering at a high temperature, has had a problem that it is difficult to enhance the color rendering since the CASN phosphor in which the oxidation reaction occurs under a high-temperature environment cannot be used. Moreover, for example, a sintered compact of a ceramic material such as YAG generally has a refractive index as large as 1.8, and accordingly, has had problems that light extraction efficiency for output light decreases and that a spot diameter increases.

Moreover, Patent Literature 2 discloses a method for manufacturing a light emitting device by using a phosphor and a binder composed of a silica-based material or a precursor thereof, and by adhering particles of the phosphor to one another by the binder cured by being heated to 500°C or less. However, in comparison with other metal oxides, silica usually has thermal conductivity as low as less than 1 W/m·K, and accordingly, there has been a problem that the heat dissipation of the wavelength converter is poor. Moreover, silica has a refractive index as high as approximately 1.5 with respect to visible light, and accordingly, there have been problems regarding optical properties such that the light extraction efficiency for the output light decreases and that the spot diameter increases.

As described above, heretofore, there have never been known a wavelength converter excellent in heat resistance and heat dissipation and light extraction efficiency even when irradiated with high-power excitation light and excellent in productivity, and a wavelength conversion member and a light emitting device, which use the wavelength converter.

The present invention has been made in consideration of the above-described problems. It is an object of the present invention to provide a wavelength converter excellent in heat resistance and heat dissipation and optical properties even when irradiated with high-power excitation light and excellent in productivity, and to provide a wavelength conversion member and a light emitting device. Note that the optical properties will be described later.

### SOLUTION TO PROBLEM

In order to solve the above-described problems, a wavelength converter according to a first aspect of the present invention includes: a plurality of phosphor particles; and a binder layer that adheres the plurality of adjacent phosphor particles to one another, the binder layer being composed of a nanoparticle-adhered body in which a plurality of nanoparticles having an average particle size D₅₀ of 1 nm or more and less than 100 nm are adhered to one another.

In order to solve the above-described problems, a wavelength conversion member according to a second aspect of the present invention includes: a substrate; and the wavelength converter formed on the substrate.

In order to solve the above-described problems, a light emitting device according to a third aspect of the present invention obtains white light by using the wavelength converter or the wavelength conversion member.

### BRIEF DESCRIPTION OF DRAWINGS

FIG. 1 is a schematic diagram of cross sections of a wavelength converter and a wavelength conversion member including the wavelength converter according to each of first to third embodiments.
FIG. 2 is a schematic cross-sectional view of the wavelength converter and the wavelength conversion member including the wavelength converter according to the first embodiment.
FIG. 3 is a schematic cross-sectional view enlargedly showing a portion A in FIG. 2.
FIG. 4 is an example of a scanning electron microscope (SEM) picture of a fracture surface of the wavelength converter according to Example 1.
FIG. 5 is an example of a transmission electron microscope (TEM) picture of a portion B in FIG. 5.
FIG. 6 is an example of a scanning electron microscope (SEM) picture of phosphor particles which are a raw material of the wavelength converter of Example 1.
FIG. 7 is an example of a graph showing a pore size distribution of nanogaps 27 of the wavelength converter according to Example 1.
FIG. 8 is a schematic cross-sectional view of the wavelength converter and the wavelength conversion member including the wavelength converter according to the second embodiment.
FIG. 9 is an example of a scanning electron microscope (SEM) picture of a fracture surface when the wavelength converter according to the second embodiment is fractured substantially along a line B-B in FIG. 8.
FIG. 10 is a schematic cross-sectional view of the wavelength converter and the wavelength conversion member including the wavelength converter according to the third embodiment.
FIG. 11 is an example of a scanning electron microscope (SEM) picture of a fracture surface including a high heat dissipation portion 50 in the wavelength converter according to the third embodiment shown in FIG. 10 and the wavelength conversion member including the wavelength converter.
FIG. 12 is a schematic diagram of cross sections of a wavelength converter and a wavelength conversion member including the wavelength converter according to a fourth embodiment.
FIG. 13 is a schematic cross-sectional view of the wavelength converter and the wavelength conversion member including the wavelength converter according to the fourth embodiment.
FIG. 14 is an example of a scanning electron microscope (SEM) picture showing a planar emission surface 2 on a cross section shown in FIG. 13.

### DESCRIPTION OF EMBODIMENTS

A description will be given below of a wavelength converter, a wavelength conversion member and a light emitting device according to embodiments of the present invention with reference to the drawings.

### [First Embodiment]

### (Wavelength conversion member)

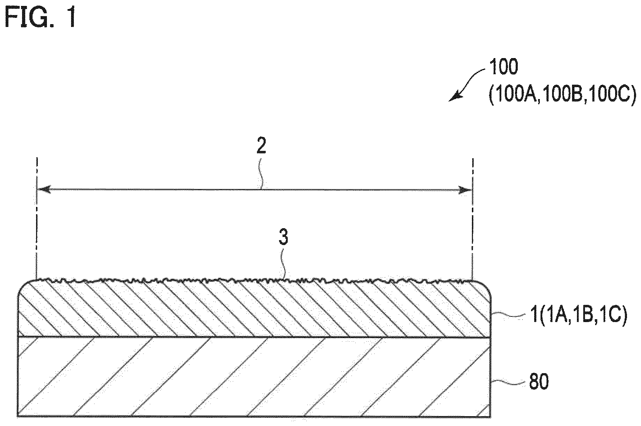

FIG. 1 is a schematic diagram of cross sections of a wavelength converter and a wavelength conversion member including the wavelength converter according to each of first to third embodiments. With regard to wavelength converters 1A, 1B and 1C according to the first to third embodiments, schematic diagrams of cross sections thereof are similar to one another, and therefore, FIG. 1 shows a single wavelength converter representing the wavelength converters 1A, 1B and 1C. Moreover, with regard to wavelength conversion members 100A, 100B and 100C, which include the wavelength converters 1A, 1B and 1C, respectively, schematic diagrams of cross sections thereof are similar to one another, and therefore, FIG. 1 shows a single wavelength conversion member representing the wavelength conversion members 100A, 100B and 100C.

As shown in FIG. 1, the wavelength conversion member 100 (100A, 100B and 100C) includes a substrate 80 and a wavelength converter 1 (1A, 1B and 1C) formed on the substrate 80. In the wavelength conversion member 100 (100A, 100B and 100C), the single wavelength converter 1 (1A, 1B and 1C) is provided on a surface of the single substrate 80. When the single wavelength converter 1 is provided on the surface of the single substrate 80, it is easy to manufacture the wavelength conversion member 100.

### (Substrate)

The substrate 80 reinforces the wavelength converter 1 formed on the surface thereof, and in addition, imparts good optical properties and thermal properties to the wavelength converter 1 by selection of a material and thickness thereof.

As the substrate 80, for example, a glass substrate, a metal substrate, a ceramic substrate or the like is used. Moreover, the substrate 80 may have translucency, or may not have translucency. When the substrate 80 has translucency, it becomes possible to apply excitation light via the substrate 80 to phosphor particles 10 in the wavelength converter 1. Meanwhile, when the substrate 80 does not have translucency, it becomes possible to reflect, by the substrate 80, the excitation light and light emitted from the wavelength converter 1.

### (Wavelength converter)

A description will be given of the wavelength converter and the wavelength conversion member according to the first embodiment. As shown in FIG. 1, the wavelength converter 1A (1) has a planar emission surface 2 formed on a surface thereof remote from the substrate 80. Here, the planar emission surface 2 means a surface of which height is substantially identical in the surface of the wavelength converter 1, the surface being remote from the substrate 80. In the wavelength converter 1 shown in FIG. 1, the planar emission surface 2 is formed except for portions, which are round in cross section and located near right and left end portions in FIG. 1.

As will be described later, the wavelength converter 1 has a structure in which the phosphor particles 10 adjacent to one another are adhered to one another by a binder layer 20. Therefore, the planar emission surface 2 that is a surface of the wavelength converter 1 is formed as an irregular surface 3 that has minute irregularities formed mainly by the phosphor particles 10. Here, the irregular surface 3 means a surface that does not satisfy Ra ≤ 0.15 µm or Rz ≤ 0.3 µm. Note that, in FIG. 1, the irregular surface 3 is shown with more emphasis than actual for convenience of description.

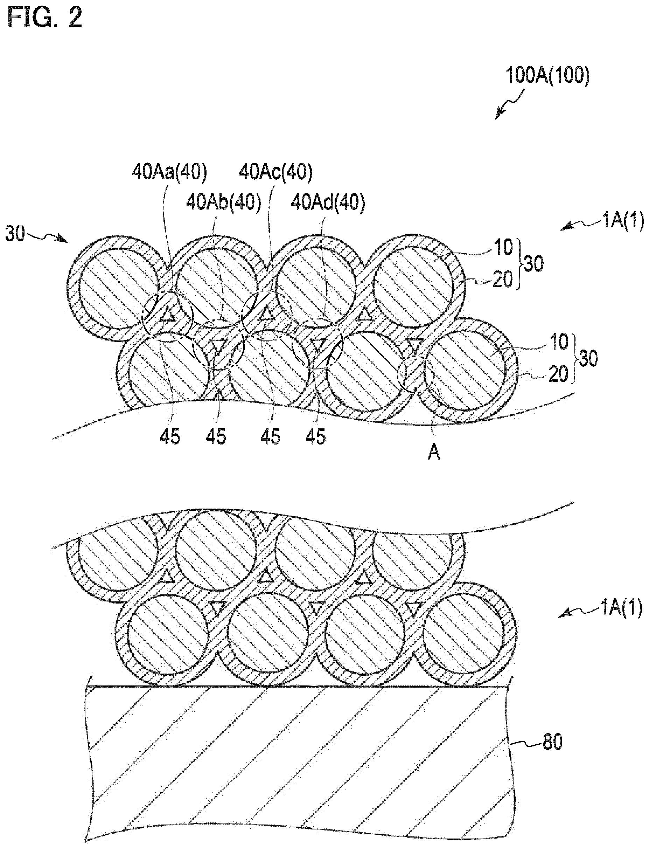

FIG. 2 is a schematic cross-sectional view of the wavelength converter and the wavelength conversion member including the wavelength converter according to the first embodiment. As shown in FIG. 2, the wavelength conversion member 100A includes the substrate 80 and the wavelength converter 1A formed on the substrate 80. The wavelength converter 1A includes the plurality of phosphor particles 10 and the binder layer 20 that adheres the adjacent phosphor particles 10 to one another. The binder layer 20 is composed of a nanoparticle-adhered body in which a plurality of nanoparticles with an average particle size D₅₀ of 1 nm or more and less than 100 nm are adhered to one another.

Moreover, in the wavelength converter 1A shown in FIG. 2, surfaces of the individual phosphor particles 10 are covered with the binder layer 20, whereby nanoparticle-covered phosphor particles 30 composed of the phosphor particles 10 and the binder layer 20 are formed. Note that the wavelength converter 1A just needs to be formed so that the binder layer 20 adheres at least the adjacent phosphor particles 10 to one another. Therefore, as another embodiment than the wavelength converter 1A shown in FIG. 2, such a wavelength converter can also be formed, in which the surfaces of the individual phosphor particles 10 are partially exposed without being covered with the binder layer 20, whereby the nanoparticle-covered phosphor particles 30 are not formed.

### <Phosphor particle>

The phosphor particles 10 just need to be capable of photoluminescence, and a type thereof is not particularly limited. As the phosphor particles 10, for example, there are used crystalline particles with a garnet structure made of YAG, that is, Y₃Al₅O₁₂, and phosphor particles made of (Sr,Ca)AlSiN₃:Eu.

It is preferable that the phosphor particles 10 include phosphor particles in which a luminance maintenance rate (L₂/L₁) is 80% or less, the luminance maintenance rate (L₂/L₁) being obtained by dividing a luminance (L₂) of the phosphor particles, which are already burnt at 1200°C or more in the atmosphere, by a luminance (L₁) of the phosphor particles, which are not still burnt at 1200°C or more in the atmosphere. It is preferable that the phosphor particles 10 include the phosphor particles in which the luminance maintenance rate (L₂/L₁) is 80% or less since a wavelength converter with high conversion efficiency and high color rendering can be achieved.

A particle size of the phosphor particles 10 contained in the wavelength converter 1A is not particularly limited, and for example, is 1 to 100 µm.

The phosphor particles 10 may be made of phosphors having the same composition, or may be a mixture of phosphor particles having two or more types of compositions.

### <Binder layer>

The binder layer 20 is composed of the nanoparticle-adhered body in which the plurality of nanoparticles having an average particle size D₅₀ of 1 nm or more and less than 100 nm (10 angstrom or more and less than 1000 angstrom) are adhered to one another, and adheres the adjacent phosphor particles 10 to one another. Here, the nanoparticle-adhered body means a body in which the nanoparticles are adhered to one another by intermolecular force. Moreover, the nanoparticles mean particles with an average particle size D₅₀ of 1 nm or more and less than 100 nm. For example, the average particle size D₅₀ of the nanoparticles is measured by a TEM (transmission electron microscope) a SEM (scanning electron microscope) or an FE-SEM (field emission-scanning electron microscope).

The average particle size D₅₀ of the nanoparticles is 1 nm or more and less than 100 nm, preferable 10 nm or more and less than 100 nm, more preferably 10 nm or more and less than 50 nm, still more preferably 15 nm or more and less than 25 nm.

When the average particle size D₅₀ of the nanoparticles is 1 nm or more and less than 100 nm, then the nanoparticles are adhered to one another by the intermolecular force, the binder layer 20 composed of the strong nanoparticle-adhered body is formed, and the adjacent phosphor particles 10 tend to be strongly adhered to one another.

Moreover, when the average particle size D₅₀ of the nanoparticles is 10 nm or more and less than 100 nm, then restricted is an occurrence of internal cracks 46 to the binder layer 20 due to thermal expansion and thermal contraction when heat treatment is carried out in order to manufacture the wavelength converter 1A, and so on. Note that, though the internal cracks 46 will be described in detail in the second embodiment, the internal cracks 46 mean groove-like gaps which are formed in the binder layer 20 and have a length of 10 µm or more and a groove width of 2 µm or less. When the internal cracks 46 are present, the internal cracks 46 are usually present in an inside of the binder layer 20 and phosphor particle-surrounded regions 40 surrounded by the phosphor particles 10 adhered to one another via the binder layer 20. Note that the internal cracks 46 are conceived not to give an optical adverse effect to the wavelength converter 1A and the wavelength conversion member 100A. A reason for the above will be described in the second embodiment.

As described above, when the average particle size D₅₀ of the nanoparticles is 10 nm or more and less than 100 nm, then the occurrence of the internal cracks 46 is restricted, whereby the heat dissipation of the wavelength converter 1 can be enhanced more, and a film strength can be enhanced. In particular, in a light emitting device of high power density excitation and a light emitting device under an environment where an impact is prone to be applied thereto, high heat dissipation and film strength are required for the wavelength converter 1A, and accordingly, it is preferable that the average particle size D₅₀ of the nanoparticles be 10 nm or more and less than 100 nm.

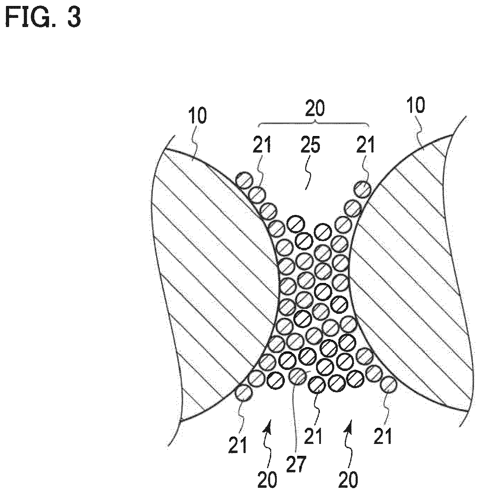

FIG. 3 is a schematic cross-sectional view enlargedly showing a portion A in FIG. 2. The portion A in FIG. 2 shows a portion where the adjacent phosphor particles 10 are adhered to one another via the binder layer 20 composed of the nanoparticle-adhered body. FIG. 3 is a view describing in detail the binder layer 20 which is composed of the nanoparticle-adhered body and interposed between the phosphor particles 10 in the portion A of FIG. 2.

As shown in FIG. 3, the binder layer 20 interposed between the adjacent phosphor particles 10 is composed of the nanoparticle-adhered body in which the plurality of nanoparticles 21 are adhered to one another by the intermolecular force. Moreover, the nanoparticles 21 which compose the nanoparticle-adhered body are also adhered to the phosphor particles 10 by the intermolecular force. In this way, the nanoparticle-adhered body functions as the binder layer 20 that adheres the adjacent phosphor particles 10 to one another.

Moreover, as shown in FIG. 3, the binder layer 20 covers entire surfaces of the phosphor particles 10. Note that the binder layer 20 does not need to cover the entire surfaces of the phosphor particles 10 as shown in FIG. 3, and among the surfaces of the phosphor particles 10, just need to cover surfaces of the phosphor particles 10 only in portions interposed between the adjacent phosphor particles 10. That is, the binder layer 20 just needs to cover at least some parts of the surfaces of the phosphor particles 10.

Note that, preferably, the binder layer 20 covers the entire surfaces of the phosphor particles 10 since there is then a case where a refractive index step between the phosphor particles 10 and the outside is restricted to enhance an absorption rate and external quantum efficiency of the phosphor particles 10. Moreover, also preferably, the binder layer 20 covers only some parts of the surfaces of the phosphor particles 10 since there is then a case where light components trapped inside the phosphor particles are increased to narrow an output spot size.

As shown in FIG. 2, in the wavelength converter 1A, the phosphor particle-surrounded regions 40 are formed in portions surrounded by the adjacent phosphor particles 10. Here, the phosphor particle-surrounded regions 40 mean regions surrounded by the phosphor particles 10 adhered to one another via the binder layer 20 in such a manner that the adjacent phosphor particles 10 are adhered to one another by the binder layer 20. Note that, on the surfaces of the phosphor particles 10 adhered to one another via the binder layer 20, the binder layer 20 may be formed, or the binder layer 20 may not be formed.

Each of the phosphor particle-surrounded regions 40Aa, 40Ab, 40Ac and 40Ad of the wavelength converter 1A shown in FIG. 2 includes a binder pore 45 that is a gap located in the binder layer 20 and has a pore size of 1 µm or more. Note that, in the wavelength converter 1A shown in FIG. 2, an example is shown where the binder pores 45 are included in all the phosphor particle-surrounded regions 40. However, as an embodiment other than the wavelength converter 1A, a wavelength converter can be adopted which has a structure in which the binder pores 45 are not included in some of the phosphor particle-surrounded regions 40. Such an embodiment in which at least some parts of the phosphor particle-surrounded regions 40 do not include the binder pores 45 will be described in the second embodiment to be described later.

Here, the binder pores 45 mean gaps which have a pore size of 0.3 µm or more and are included inside the binder layer 20. Therefore, for example, gaps formed in portions other than the binder layer 20, gaps open to the binder layer 20 and gaps having a pore size of less than 0.3 µm are not included in the binder pores 45. Moreover, the pore size means a diameter of the binder pores 45 when a shape thereof is assumed to be perfectly spherical. Usually, the pore size of the binder pores 45 approximately ranges from 5 to 15 µm.

The shape of the binder pores 45 is not particularly limited; however, is usually spherical. An aspect ratio (minor axis: length) of the binder pores 45 is usually 1: 1 to 1: 10. Note that, for convenience, a cross-sectional shape of the binder pores 45 is shown as a triangular shape in FIG. 2, and FIGS. 8, 10 and 13 to be described later. The actual binder pores 45 tend to be spherical since joint portions of the binder layer 20 are rounded due to necking.

The binder pores 45 affect scattering of visible light in the wavelength converter 1A. For example, if the binder layer 20 includes a large number of the binder pores 45 having a pore size of 0.3 µm to 20 µm, in which the scattering of the visible light is prone to occur, then the scattering of the visible light in the wavelength converter 1A occurs much. This case is not preferable since waveguide components in the wavelength converter 1A then tend to be increased to sometimes result in an increase of the spot size of the output light.

Meanwhile, if the binder layer 20 includes a small number of the binder pores 45 having a pore size of 0.3 µm to 20 µm, in which the scattering of the visible light is prone to occur, then the scattering of the visible light in the wavelength converter 1A occurs less. This case is preferable since the waveguide components in the wavelength converter 1A then tend to be reduced to result in effects of enhancing light extraction efficiency and narrowing the output spot size.

Therefore, it is preferable that, in the wavelength converter 1A, at least some parts of the phosphor particle-surrounded regions 40 surrounded by the phosphor particles 10 adhered to one another via the binder layer 20 not include the binder pores 45 which are the gaps having a pore size of 0.3 µm or more in the binder layer 20. It is preferable that at least some parts of the phosphor particle-surrounded regions 40 not include the binder pores 45 since the waveguide components in the wavelength converter 1A then tend to be reduced to result in the enhancement of the light extraction efficiency and the narrowing of the output spot size.

As a material of the nanoparticles, used is an inorganic material that enables the nanoparticles to adhere to one another by the intermolecular force and has high transmissivity for the excitation light. As the material of the nanoparticle, for example, aluminum oxide (alumina), silicon dioxide, titanium oxide, zinc oxide, zirconium oxide and boron nitride can be used. These materials have strong intermolecular force between the nanoparticles, and make it easy to form the binder layer 20 composed of the strong nanoparticle-adhered body. As the nanoparticles, nanoparticles made of one or more materials selected from the materials described above can be used.

Moreover, thermal conductivity of the material of the nanoparticles at 25°C is preferably larger than 1 W/m·K, more preferably larger than 4 W/m·K. Furthermore, the thermal conductivity of the material of the nanoparticles at 25°C is preferably less than 50 W/m·K, more preferably less than 30 W/m·K. When the thermal conductivity of the nanoparticles at 25°C stays within the range described above, the heat dissipation of the wavelength converter 1A is increased. For example, thermal conductivity of aluminum oxide at 25°C is 30 W/m·K, and thermal conductivity of silicon dioxide at 25°C is 1 W/m·K.

If an organic substance is contained in the binder layer 20, when the binder layer 20 is irradiated with high-power excitation light of a laser light source or the like, it is apprehended that the organic substance contained in the binder layer 20 may be discolored and burnt to decrease light transmittance. Therefore, it is preferable that the binder layer 20 contain the organic substance as little as possible; however, an organic substance such as a dispersant may be added thereto as appropriate in response to a power density of the excitation light.

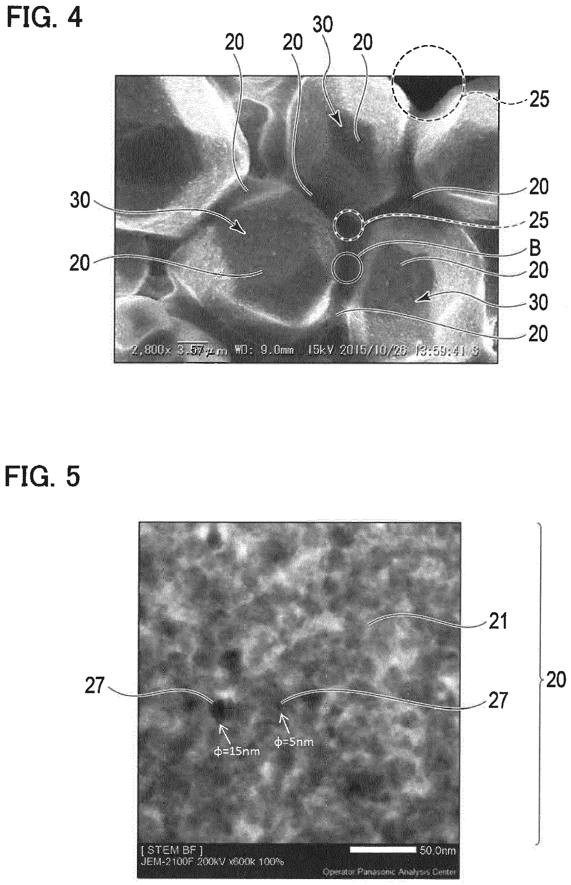

Moreover, the binder layer 20 composed of the nanoparticle-adhered body may include therein nanogaps (minute gaps) 27 as shown in FIG. 3 and FIG. 5 to be described later. Here, the nanogaps 27 mean gaps which have a pore size of less than 0.3 µm and are formed in the binder layer 20. Therefore, the nanogaps 27 do not include gaps formed in portions other than the binder layer 20 or gaps having a pore size of 0.3 µm or more. Moreover, the pore size means a diameter of the nanogaps 27 when a shape thereof is assumed to be perfectly spherical. Usually, the pore size of the nanogaps 27 approximately ranges from 5 to 15 nm.

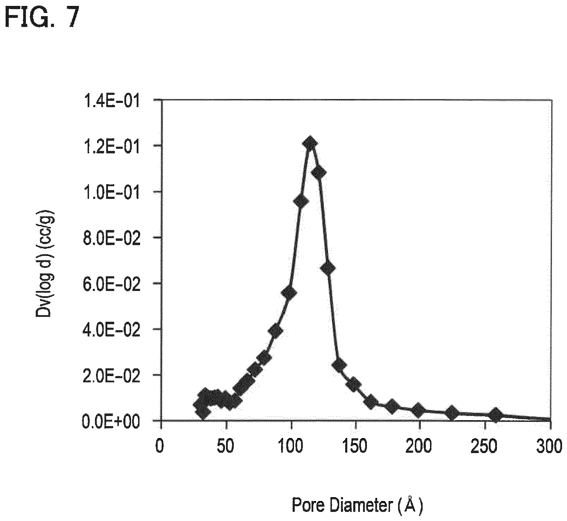

FIG. 7 is an example of a graph showing a pore size distribution of nanogaps 27 of a wavelength converter according to Example 1 to be described later. As shown in FIG. 7, an average pore size of the nanogaps 27 is approximately 100 Å (10 nm).

The shape of the nanogaps 27 is not particularly limited; however, is usually spherical. An aspect ratio (minor axis: length) of the nanogaps 27 is usually 1: 1 to 1: 10. The nanogaps 27 are gaps which remain between the nanoparticles 21 when the nanoparticles 21 are adhered to one another to form the nanoparticle-adhered body.

The nanogaps 27 decrease the refractive index of the binder layer 20, and increase light components trapped in the phosphor particles 10, thereby developing an effect of enhancing light extraction efficiency from the binder layer 20. Therefore, it is preferable that the binder layer 20 include the nanogaps 27 since efficiency of the output light is then enhanced in some cases while narrowing the output spot size.

Hence, it is preferable that, in the wavelength converter 1A, the binder layer 20 include therein the nanogaps 27 which are gaps having a pore size of less than 0.3 µm.

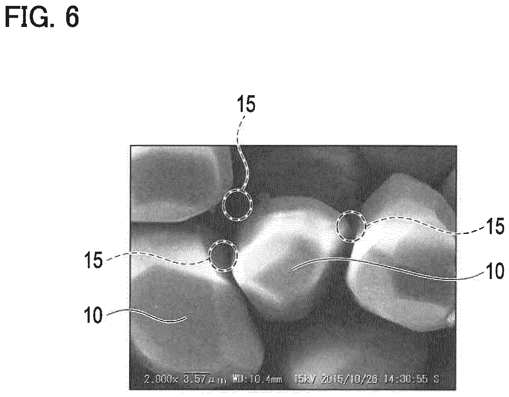

There is shown an example of a scanning electron microscope (SEM) picture or transmission electron microscope (TEM) picture of a fracture surface of the wavelength converter 1A. FIG. 4 is an example of a scanning electron microscope (SEM) picture of a fracture surface of the wavelength converter according to Example 1 to be described later. FIG. 5 is an example of a transmission electron microscope (TEM) picture of a portion B in FIG. 4. FIG. 6 is an example of a scanning electron microscope (SEM) picture of phosphor particles which are a raw material of the wavelength converter according to Example 1 to be described later.

As shown in FIG. 4, the binder layer 20 is formed on the surfaces of the phosphor particles (YAG particles) 10 and between the phosphor particles 10, and the adjacent phosphor particles 10 are adhered to one another by the binder layer 20, whereby the wavelength converter 1A is formed. The binder layer 20 is composed of the nanoparticle-adhered body in which a plurality of the nanoparticles 21 made of aluminum oxide are adhered to one another.

FIG. 6 shows a SEM picture of the phosphor particles 10 on and between which the binder layer 20 is not formed. As shown in FIG. 6, in the phosphor particles 10 on and between which the binder layer 20 is not formed, gaps 15 are formed between the adjacent phosphor particles 10, and the adjacent phosphor particles 10 are not adhered to one another.

As shown in FIG. 4, in the wavelength converter 1A, the surfaces of the individual phosphor particles 10 shown in FIG. 6 are covered with the binder layer 20 composed of the nanoparticle-adhered body made of aluminum oxide, and in addition, the binder layer 20 described above is interposed between the phosphor particles 10. However, the portions between the adjacent phosphor particles 10 are not completely filled with the binder layer 20 without any clearance, and the gaps 25 are partially formed in the binder layer 20. Note that, in wavelength converters in other than this embodiment, the portions between the adjacent phosphor particles 10 can be filled with the binder layer 20 without any clearance unlike the wavelength converter 1 shown in FIG. 4.

FIG. 5 is an example of the transmission electron microscope (TEM) picture of the portion B of the binder layer 20 in FIG. 4. FIG. 5 enlarges the portion B in FIG. 4 for observation. As shown in FIG. 5, the binder layer 20 is composed of the nanoparticle-adhered body in which the plurality of nanoparticles 21 made of aluminum oxide are adhered to one another. Moreover, as shown in FIG. 5, the nanogaps 27 having a diameter of approximately 15 nm and 5 nm are formed in the binder layer 20 composed of the nanoparticle-adhered body. It is conceived that these nanogaps 27 are gaps which have remained between the nanoparticles 21 when the plurality of nanoparticles 21 are adhered to one another to form the binder layer 20 composed of the nanoparticle-adhered body.

A thickness of the wavelength converter 1A is not particularly limited; however, for example, is set to 40 to 400 µm, preferably 80 to 200 µm. It is preferable that the thickness of the wavelength converter 1A stay within such a range as described above since the heat dissipation can be maintained to be relatively high at that time.

### (Manufacturing method of wavelength converter)

For example, the wavelength converter 1A can be manufactured by the following method. First, a solution in which the nanoparticles 21 are dispersed and the phosphor particles 10 are mixed with each other, whereby a mixed solution is prepared. Note that a dispersant is added to the mixed solution according to needs. A viscosity of the mixed solution is adjusted, for example, so that the mixed solution turns to a paste form. The viscosity is adjusted, for example, by adjusting concentrations of solid contents of the nanoparticles 21, the phosphor particles 10 and the like.

Next, this mixed solution in the paste form is applied onto the substrate 80 such as a metal substrate. For the application of the mixed solution in the paste form, for example, used are a variety of known application methods such as application using an applicator equipped with a bar coater and screen printing, which are carried out under a normal pressure environment.

Moreover, the mixed solution in the paste form on the substrate 80 is solidified by being dried. A dried body formed by the solidification of the mixed solution becomes the wavelength converter 1A including: the plurality of phosphor particles 10; and the binder layer 20 that adheres the adjacent phosphor particles 10 to one another, the phosphor particles 10 being composed of the nanoparticle-adhered body in which the plurality of nanoparticles 21 are adhered to one another.

The mixed solution is dried, for example, by leaving the substrate 80 applied with the mixed solution in the paste form standing at a normal temperature, or by heating the substrate 80. A heating temperature in the case of heating the substrate 80 is, for example, 100°C.

The binder layer 20 is composed of the nanoparticle-adhered body in which the plurality of nanoparticles 21 are adhered to one another, and can be fabricated by only removing a solvent such as water from the mixed solution containing the nanoparticles 21. In the binder layer 20, it is not necessary to bake the nanoparticles 21. As described above, the wavelength converter 1A of this embodiment can be manufactured without being heated at a high temperature, and accordingly, has high productivity. Moreover, in the wavelength converter 1A, a deterioration of the phosphor particles 10 due to high-temperature heating is less likely to occur.

### <Functions of wavelength converter and wavelength conversion member according to first embodiment>

A description will be given of functions of the wavelength converter 1A and the wavelength conversion member 100A. The wavelength converter 1A that composes the wavelength conversion member 100A of this embodiment is irradiated with the excitation light, whereby the phosphor particles 10 in the wavelength converter 1A are excited to radiate secondary light. Note that the binder layer 20 composed of the nanoparticle-adhered body in which the plurality of nanoparticles 21 are adhered to one another is formed on the surfaces of the phosphor particles 10. However, since the nanoparticles 21 have high transmissivity for the excitation light, and have a relatively small effect of scattering light (have a small scattering cross-sectional area), the excitation light is transmitted through the binder layer 20 and applied to the phosphor particles 10, and the phosphor particles 10 are excited and capable of radiating the secondary light.

When the substrate 80 that composes the wavelength conversion member 100A is such a substrate 80 having low light transmissivity, the secondary light generated in the wavelength converter 1A is radiated from a front surface side of the wavelength converter 1A. Moreover, when the substrate 80 that composes the wavelength conversion member 100A is such a substrate 80 having high light transmissivity, the secondary light generated in the wavelength converter 1A is radiated from the front surface side of the wavelength converter 1A and a front surface side of the substrate 80.

### <Effects of wavelength converter and wavelength conversion member according to first embodiment>

The nanoparticle-adhered body that composes the binder layer 20 of the wavelength converter 1A that composes the wavelength conversion member 100A is a body in which the plurality of nanoparticles which are an inorganic material having high heat resistance and heat dissipation are adhered to one another. Therefore, even in the case of using, as excitation light, the high-power excitation light of the laser light source or the like, the wavelength converter 1A and the wavelength conversion member 100A according to the first embodiment have high heat resistance and heat dissipation. Since the heat dissipation of the binder layer 20 is high as described above, and therefore, even in the case of using, as excitation light, the high-power excitation light of the laser light source or the like, temperature quenching due to a temperature rise of the phosphor particles 10 is less likely to occur in the wavelength converter 1A and the wavelength conversion member 100A according to the first embodiment.

Moreover, in the wavelength converter 1A and the wavelength conversion member 100A according to the first embodiment, the refractive index of the binder layer 20 is lowered by the nanogaps 27. Therefore, in accordance with the wavelength converter 1A and the wavelength conversion member 100A according to the first embodiment, it is easy to develop the effect of increasing the light components trapped in the phosphor particles 10 and enhancing the light extraction efficiency from the binder layer 20, and it is easy to narrower the output spot size. This effect is particularly significant when an amount of reflection component of the visible light on an interface between the wavelength converter 1A and the substrate is relatively large. As described above, the wavelength converter 1A and the wavelength conversion member 100A according to the first embodiment are excellent in optical properties.

Moreover, an amount of the organic substance contained in the binder layer 20 of the wavelength converter 1A is as small as approximately an amount of no more than impurities. Accordingly, even in the case of using the high-power excitation light of the laser light source or the like, such discoloration and burning of the binder layer 20 due to thermal degradation of the organic substance are less likely to occur. Accordingly, the wavelength converter 1A and the wavelength conversion member 100A according to the first embodiment have high heat resistance.

Furthermore, the binder layer 20 of the wavelength converter 1A is composed of the nanoparticle-adhered body in which the plurality of nanoparticles are adhered to one another, and in the binder layer 20, it is not necessary to bake the nanoparticles 21. As described above, since the binder layer 20 can be formed without baking the nanoparticles 21 at high temperature, the wavelength converter 1A and the wavelength conversion member 100A according to the first embodiment have high productivity.

Moreover, in the wavelength converter 1A and the wavelength conversion member 100A according to the first embodiment, since the binder layer 20 can be formed without being sintered at high temperature, a phosphor that has low heat resistance can be used as the phosphor particles 10. For example, the (Sr,Ca)AlSiN₃:Eu has excellent color rendering, but causes an oxidation reaction under a high-temperature environment. Accordingly, in the conventional wavelength converter and the wavelength conversion member, which include the binder layer sintered at high temperature, the oxidation reaction occurs in the phosphor, and the color rendering is prone to decrease. In contrast, in the wavelength converter 1A and the wavelength conversion member 100A according to the first embodiment, since the binder layer 20 can be formed without baking the nanoparticles 21 at high temperature, the phosphor described above can also be used as the phosphor particles 10, and the color rendering can be enhanced.

Note that, in the wavelength converter 1A according to the first embodiment, a mode is indicated in which the nanoparticles 21 that composes the binder layer 20 and the phosphor particles 10 are not subjected to surface treatment or the like. However, in the wavelength converters in other than the first embodiment, at least either of the nanoparticles 21 that composes the binder layer 20 and the phosphor particles 10 may be subjected to the surface treatment as long as the heat dissipation of the wavelength converter is not inhibited. This surface treatment is performed for the surfaces of the nanoparticles 21, for example, in order to enhance adhesion between the nanoparticles 21 which compose the binder layer 20 composed of the nanoparticle-adhered body and to enhance compactness of the nanoparticle-adhered body. Moreover, the above-described surface treatment is performed for at least either of the nanoparticles 21 and the phosphor particles 10 in order to enhance adhesion between the binder layer 20 and the phosphor particles 10 and to enhance compactness of the wavelength converter. The surface treatment in this case can be suitably used for the case where the power of the excitation light is relatively weak.

### [Second Embodiment]

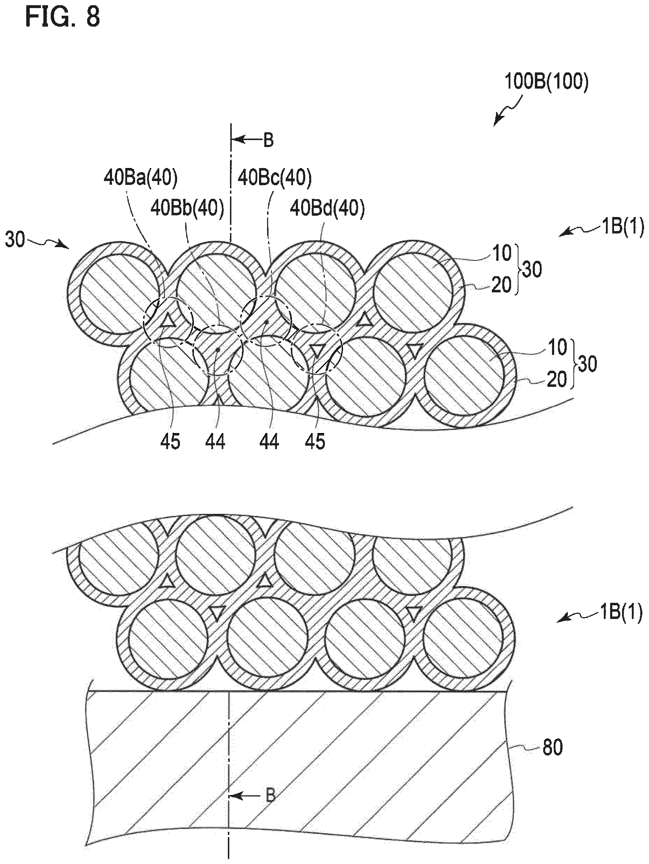

A description will be given of the wavelength converter and the wavelength conversion member according to the second embodiment. FIG. 8 is a schematic cross-sectional view of the wavelength converter and the wavelength conversion member including the wavelength converter according to the second embodiment. As shown in FIG. 8, the wavelength conversion member 100B includes the substrate 80 and the wavelength converter 1B formed on the substrate 80.

The wavelength conversion member 100B uses the wavelength converter 1B in place of the wavelength converter 1A in the wavelength conversion member 100A according to the first embodiment shown in FIG. 2. Moreover, the wavelength converter 1B is different from the wavelength converter 1A according to the first embodiment shown in FIG. 2 in that some parts of the phosphor particle-surrounded regions 40 do not include the binder pores 45 but include solid portions 44, and other points are the same therebetween.

Therefore, the same reference numerals are assigned to the same constituents between the wavelength converter 1B and the wavelength conversion member 100B, which are shown in FIG. 8, and the wavelength converter 1A and the wavelength conversion member 100A according to the first embodiment shown in FIG. 2, and descriptions of configurations and functions of the same constituents are omitted or simplified.

As shown in FIG. 8, among the phosphor particle-surrounded regions 40 of the wavelength converter 1B, the phosphor particle-surrounded regions 40Ba and 40Bd include the binder pores 45, and the phosphor particle-surrounded regions 40Bb and 40Bc include the solid portions 44. Here, the solid portions 44 mean portions which do not include the binder pores 45 and are composed of only the nanoparticle-adhered body that substantially composes the binder layer 20 among portions in the phosphor particle-surrounded regions 40. Note that the solid portions 44 may include the internal cracks 46 which are gaps smaller in volume than the binder pores 45.

That is, in the wavelength converter 1B shown in FIG. 8, at least some parts of the phosphor particle-surrounded regions 40 surrounded by the phosphor particles 10 adhered to one another via the binder layer 20 are configured so as not to include the binder pores 45 which are the gaps having a pore size of 0.3 µm or more in the binder layer 20.

As described above, the binder pores 45 affect scattering of visible light in the wavelength converter 1B. For example, if the binder layer 20 includes a small number of the binder pores 45 having a pore size of 0.3 µm to 20 µm, in which the scattering of the visible light is prone to occur, then the scattering of the visible light in the wavelength converter 1B occurs less. This case is preferable since waveguide components in the wavelength converter 1B then tend to be reduced to result in effects of enhancing the light extraction efficiency and narrowing the output spot size.

A preferable effect of the wavelength converter 1B, which is brought by the fact that a content of the above-described binder pores 45 is small, is developed in such a manner that the wavelength converter 1B includes the binder pores 45 in a specific ratio. The preferable effect of the wavelength converter 1B, which is brought by the fact that the content of the above-described binder pores 45 is small, is developed, for example, in such a manner that the wavelength converter 1B includes the binder pores 45 in a ratio of 39% by volume or less.

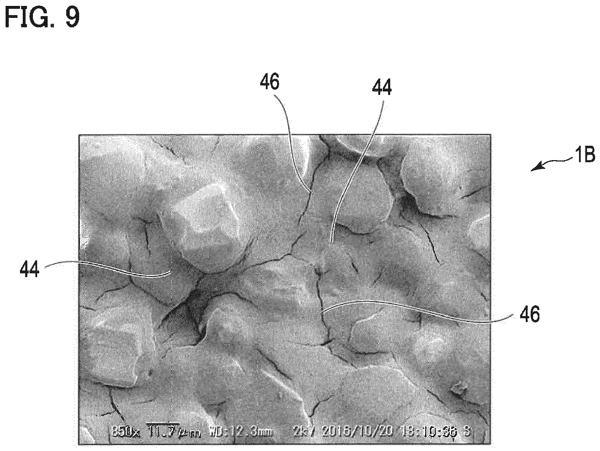

FIG. 9 is an example of a scanning electron microscope (SEM) picture of a fracture surface when the wavelength converter 1B according to the second embodiment is fractured substantially along a line B-B in FIG. 8. As shown in FIG. 9, the solid portions 44 which do not include the binder pores 45 are formed in such a fracture surface of each of the phosphor particle-surrounded regions 40 of the wavelength converter 1B. That is, in the fracture surface shown in FIG. 9, the phosphor particle-surrounded regions 40 of the wavelength converter 1B has a highly filled structure.

As shown in FIG. 9, the solid portions 44 have the internal cracks 46 which are groove-like gaps. Here, the internal cracks 46 mean groove-like gaps which are formed in the binder layer 20 and have a length of 10 µm or more and a groove width of 2 µm or less. The length and groove width of the internal cracks 46 can be confirmed by microscopy for the fracture surface, for example, as can be confirmed in FIG. 9. An aspect ratio (minor axis: length) of the internal crack 46 is usually more than 1: 10 and 1: 1000 or less. Note that the internal cracks 46 and the binder pores 45 are distinguishable from each other since a numerical range of the aspect ratio (minor axis: length) is different therebetween.

The internal cracks 46 are not formed on purpose, and are usually conceived to occur due to thermal expansion and contraction of raw materials of the wavelength converter 1B when the raw materials are heated and dried in manufacturing the wavelength converter 1B. Therefore, in the wavelength converter 1B, it is conceived that optimization of manufacturing conditions thereof enable a reduction of the occurrence of the internal cracks 46 in the solid portions 44, and it is conceived that such a reduction of the occurrence of the internal cracks 46 improves strength of the film.

As will be described later, in view of a shape, size and presence frequency of the internal cracks 46, it is conceived that the internal cracks 46 do not give the wavelength converter 1B and the wavelength conversion member 100B an influence bad enough to cancel the optical effect obtained in the present invention. Therefore, the internal cracks 46 are clearly distinguished from the binder pores 45 of the present invention.

### <Functions of wavelength converter and wavelength conversion member according to second embodiment>

Functions of the wavelength converter 1B and the wavelength conversion member 100B are similar to the functions of the wavelength converter 1A and the wavelength conversion member 100A according to the first embodiment.

Moreover, in the wavelength converter 1B, at least some parts of the phosphor particle-surrounded regions 40 are configured so as not to include the binder pores 45. Therefore, in comparison with the wavelength converter 1A and the wavelength conversion member 100A according to the first embodiment, the wavelength converter 1B and the wavelength conversion member 100B have a function to further reduce the waveguide components of the excitation light of the wavelength converter 1B.

Note that, in view of the shape and size of the internal cracks 46, it is conceived that the internal cracks 46 have a small function to scatter the visible light and have a large function to transmit/reflect the visible light. Therefore, it is conceived that, even if the internal cracks 46 are present, the internal cracks 46 do not give the wavelength converter 1B and the wavelength conversion member 100B such an influence bad enough to cancel the optical effect obtained in the present invention.

### <Effects of wavelength converter and wavelength conversion member according to second embodiment>

Effects of the wavelength converter 1B and the wavelength conversion member 100B are similar to the effects of the wavelength converter 1A and the wavelength conversion member 100A according to the first embodiment.

Moreover, in the wavelength converter 1B and the wavelength conversion member 100B, at least some parts of the phosphor particle-surrounded regions 40 are configured so as not to include the binder pores 45. Therefore, the wavelength converter 1B and the wavelength conversion member 100B exert an effect of enhancing the adhesion between the binder layer 20 and the substrate 80 having a relatively high thermal expansion coefficient more than the wavelength converter 1A and the wavelength conversion member 100A according to the first embodiment.

Moreover, since at least some parts of the phosphor particle-surrounded regions 40 do not include the binder pores 45, the wavelength converter 1B and the wavelength conversion member 100B exert an effect of reducing the waveguide components more than the wavelength converter 1A and the wavelength conversion member 100A. Therefore, in comparison with the wavelength converter 1A and the wavelength conversion member 100A according to the first embodiment, the wavelength converter 1B and the wavelength conversion member 100B have more excellent optical properties since there it is easy to enhance the light extraction efficiency and to narrow the output spot size.

### [Third Embodiment]

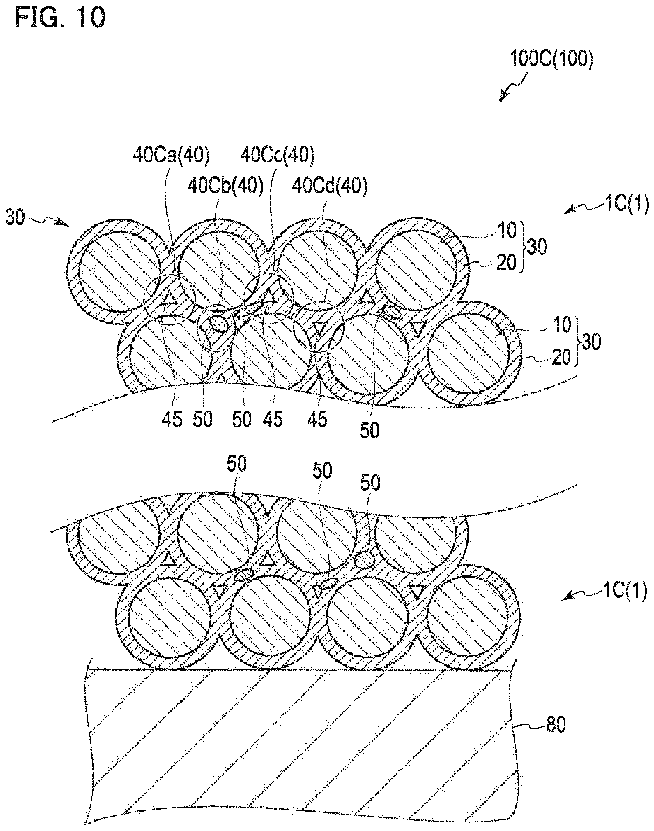

A description will be given of the wavelength converter and the wavelength conversion member according to the third embodiment. FIG. 10 is a schematic cross-sectional view of the wavelength converter and the wavelength conversion member including the wavelength converter according to the third embodiment. As shown in FIG. 10, the wavelength conversion member 100C includes the substrate 80 and the wavelength converter 1C formed on the substrate 80.

The wavelength conversion member 100C uses the wavelength converter 1C in place of the wavelength converter 1A in the wavelength conversion member 100A according to the first embodiment shown in FIG. 2. Moreover, the wavelength converter 1C is different from the wavelength converter 1A according to the first embodiment shown in FIG. 2 in that the binder layer 20 further includes high heat dissipation portions 50, and other points are the same therebetween.

Therefore, the same reference numerals are assigned to the same constituents between the wavelength converter 1C and the wavelength conversion member 100C, which are shown in FIG. 10, and the wavelength converter 1A and the wavelength conversion member 100A according to the first embodiment shown in FIG. 2, and descriptions of configurations and functions of the same constituents are omitted or simplified.

As shown in FIG. 10, in the wavelength converter 1C, the high heat dissipation portions 50 are further provided between adjacent portions of the binder layer 20. Here, the high heat dissipation portions 50 mean portions which are made of a material in which thermal conductivity at 25°C is higher than that of the nanoparticles 21 and have a particle size of 1 µm or more. If the binder layer 20 includes the high heat dissipation portions 50 made of the material in which the thermal conductivity at 25°C is higher than that of the nanoparticles 21, then the heat dissipation of the wavelength converter 1C and the wavelength conversion member 100C is increased, and an efficiency decrease due to the temperature quenching can be prevented.

In the high heat dissipation portions 50, the thermal conductivity thereof at 25°C is usually 10 W/m·K or more, preferably 35 W/m·K or more, more preferably 50 W/m·K or more. If the thermal conductivity of the high heat dissipation portions 50 at 25°C stays within the above-described range, then the heat dissipation of wavelength converter 1C and the wavelength conversion member 100C becomes sufficiently high, and the efficiency decrease due to the temperature quenching can be prevented effectively. Note that, when the high heat dissipation portions 50 have anisotropy of the thermal conductivity, it is preferable that thermal conductivity of the high heat dissipation portions 50 in an orientation in which the thermal conductivity is highest stay within the above-described range since the heat dissipation of the wavelength converter 1C and the wavelength conversion member 100C becomes sufficiently high.

A shape of the high heat dissipation portions 50 is not particularly limited; however, for example, can be granular, scale leaf-like, and so on. When the phosphor particles 10 include phosphor particles 10 having a shape derived from a garnet structure of the phosphor particles 10, it is preferable that the shape of the high heat dissipation portions 50 be scale leaf-like since a particle packing density of the wavelength converter 1C can be increased.

As shown in FIG. 10, the high heat dissipation portions 50 are included between the adjacent portions of the binder layer 20. That is, the surfaces of the high heat dissipation portions 50 are configured to contact the binder layer 20 without contacting the phosphor particles 10. In the case where, as described above, each of the high heat dissipation portions 50 is interposed between the portion of the binder layer 20, which is formed on the surface of the phosphor particle 10 on one side, and the portion of the binder layer 20, which is formed on the surface of the phosphor particle 10 on other side, this case is preferable since thermal conduction between the portions of the binder layer 20 is enhanced.

As a material of the high heat dissipation portions 50, for example, a boron nitride, aluminum oxide and the like are used. Among them, boron nitride is preferable since thermal conductivity thereof at 25°C is high.

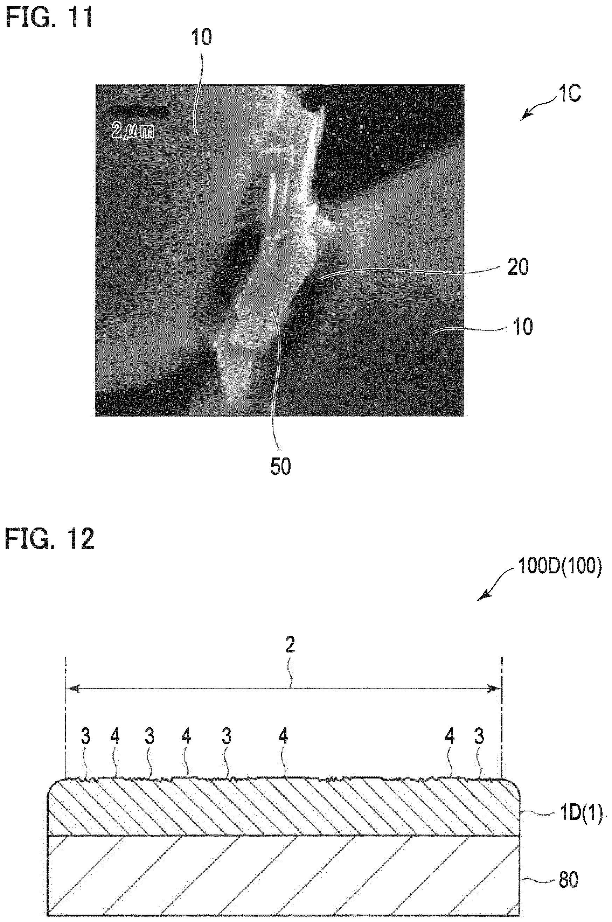

FIG. 11 is an example of a scanning electron microscope (SEM) picture of a fracture surface including the high heat dissipation portion 50 in the wavelength converter according to the third embodiment shown in FIG. 10 and the wavelength conversion member including the wavelength converter. As shown in FIG. 11, the high heat dissipation portion 50 is interposed between the portion of the binder layer 20, which is formed on the surface of phosphor particle 10 on one side, and the portion of the binder layer 20, which is formed on the surface of the phosphor particle 10 on the other side.

### <Functions of wavelength converter and wavelength conversion member according to third embodiment>

Functions of the wavelength converter 1C and the wavelength conversion member 100C are similar to the functions of the wavelength converter 1A and the wavelength conversion member 100A according to the first embodiment.

Moreover, the wavelength converter 1C includes the high heat dissipation portions 50 made of the material in which the thermal conductivity at 25°C is higher than that of the nanoparticles 21. Therefore, in comparison with the wavelength converter 1A and the wavelength conversion member 100A according to the first embodiment, the wavelength converter 1C and the wavelength conversion member 100C have higher heat dissipation, and can further prevent the efficiency decrease due to the temperature quenching.

### <Effects of wavelength converter and wavelength conversion member according to third embodiment>

Effects of the wavelength converter 1C and the wavelength conversion member 100C are similar to the effects of the wavelength converter 1A and the wavelength conversion member 100A according to the first embodiment.

Moreover, since the high heat dissipation portions 50 are further provided between the adjacent portions of the binder layer 20, the wavelength converter 1C and the wavelength conversion member 100C have higher heat dissipation than the wavelength converter 1A and the wavelength conversion member 100A according to the first embodiment, and can further prevent the efficiency decrease due to the temperature quenching.

### [Fourth Embodiment]

A description will be given of a wavelength converter and a wavelength conversion member according to a fourth embodiment. FIG. 12 is a schematic diagram of cross sections of the wavelength converter and the wavelength conversion member including the wavelength converter according to the fourth embodiment.

As shown in FIG. 12, a wavelength conversion member 100D (100) includes the substrate 80 and a wavelength converter 1D (1) formed on the substrate 80. In the wavelength conversion member 100D, the single wavelength converter 1D is provided on the surface of the single substrate 80. When the single wavelength converter 1D is provided on the surface of the single substrate 80, it is easy to manufacture the wavelength conversion member 100D.

The wavelength conversion member 100D (100) according to the fourth embodiment is a member in which the wavelength converter 1A is replaced by the wavelength converter 1D in the wavelength conversion member 100A according to the first embodiment. As the substrate 80, a similar one to that of the wavelength conversion member 100A according to the first embodiment is used.

As shown in FIG. 12, in a similar way to the wavelength converter 1A according to the first embodiment, the wavelength converter 1D (1) according to the fourth embodiment includes the planar emission surface 2 on the surface of the substrate 80, the surface being remote from the substrate 80. However, unlike the wavelength converter 1A according to the first embodiment, in the wavelength converter 1D (1), the planar emission surface 2 has the irregular surface 3 and a planar surface 4. Here, the planar surface 4 is a surface having less irregularities than the irregular surface 3, and specifically means a surface that satisfies Rₐ ≤ 0.15 µm and R_{z} ≤ 0.3 µm. That is, at least a part of the planar emission surface 2 is the planar surface 4 that satisfies Rₐ ≤ 0.15 µm and R_{z} ≤ 0.3 µm. Note that, in FIG. 12, the irregular surface 3 is shown with more emphasis than actual for convenience of description.

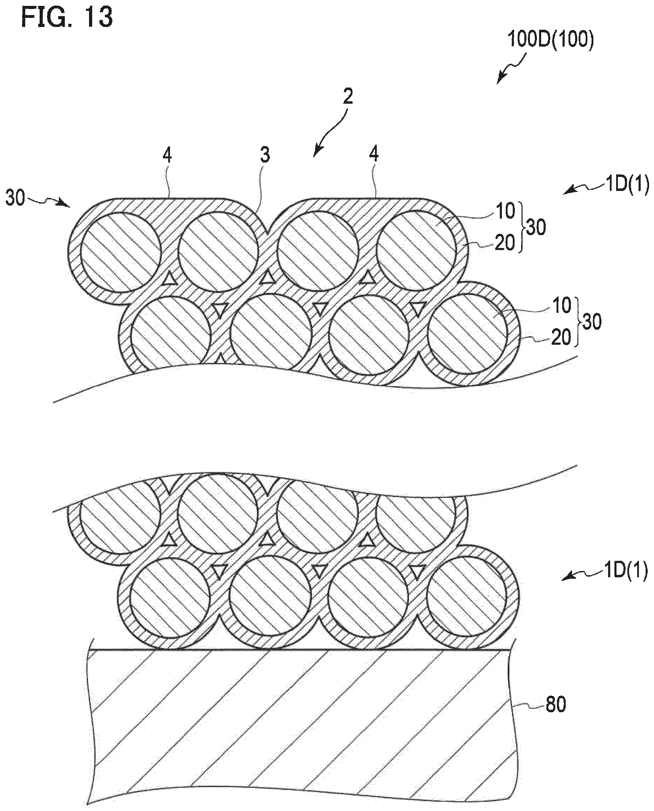

FIG. 13 is a schematic cross-sectional view of the wavelength converter and the wavelength conversion member including the wavelength converter according to the fourth embodiment. FIG. 13 is a view showing more in detail a cross section of the wavelength converter 1D (1) shown in FIG. 12.

As shown in FIGS. 12 and 13, the wavelength converter 1D corresponds to a wavelength converter in which the planar emission surface 2 has the irregular surface 3 and the planar surface 4 in the wavelength converter 1D according to the first embodiment shown in FIG. 2. As shown in FIG. 13, the planar surface 4 is obtained, for example, in such a manner that at least a part of the surface of the binder layer 20, which forms the planar emission surface 2, becomes planar.

The binder layer 20 is composed of a nanoparticle-adhered body 23 in which the plurality of nanoparticles 21 are adhered to one another. This binder layer 20 is obtained, for example, by forming the nanoparticle-adhered body 23 in such a manner that the nanoparticles 21 filled between the phosphor particles 10 are adhered to one another by heating/drying treatment or the like in manufacturing the wavelength converter 1D. Therefore, the planar surface 4 shown in FIG. 13 is formed on a peeled surface, for example, obtained when a wavelength converter is fabricated by using the nanoparticles 21 having high fluidity, in which the substrate 80 and the binder layer 20 are in close contact with each other on a planer interface therebetween, and that the wavelength converter is then peeled off from the substrate 80. Moreover, when front and back surfaces of the peeled wavelength converter are inverted, and the wavelength converter and the substrate 80 are adhered to each other so that the surface including the peeled surface becomes a new planar emission surface 2, then the wavelength conversion member 100D is obtained, which includes the wavelength converter 1D having the planar emission surface 2 including the planar surface 4.

Occupancy of the planar surface 4 with respect to an area of the planar emission surface 2 is preferably 36% or more, more preferably 65.5% or more. If the occupancy of the planar surface 4 stays within the above-described range, it is easy to enhance absorption efficiency of the excitation light. Therefore, the wavelength converter 1D in which the occupancy of the planar surface 4 stays within the above-described range and the wavelength conversion member 100D including the wavelength converter 1D are useful for the purpose of a projector or the like.

Moreover, in the wavelength converter 1D according to the fourth embodiment, the surface thereof on the planar emission surface 2 side may be subjected to known anti-reflective coating treatment such as AR coating. When the planar emission surface 2 side-surface of the wavelength converter 1D is subjected to the anti-reflective coating treatment, then it is easy to enhance the absorption efficiency and light extraction efficiency of the excitation light.

Moreover, in the wavelength converter 1D according to the fourth embodiment, though not shown, surface cracks which are groove-like gaps may be formed on the surface thereof on the planar emission surface 2 side. Here, for example, the surface cracks are grooves having a width of 10 µm or more and a depth of 1 µm or more.

Note that, in the wavelength converter 1B according to the second embodiment, the internal cracks 46 are formed in the solid portions 44 in the inside of the wavelength converter 1B. In contrast, in the wavelength converter 1D according to the fourth embodiment, the surface cracks are formed on the surface thereof on the planar emission surface 2 side. As described above, formed places of the surface cracks and the internal crack 46 are different from each other, and accordingly, the surface cracks and the internal cracks 46 are distinguishable from each other.

The surface cracks in the fourth embodiment are not formed on purpose, and in a similar way to the internal cracks 46 in the second embodiment, are usually conceived to occur due to thermal expansion and contraction of raw materials of the wavelength converter 1D when the raw materials are heated and dried in manufacturing the wavelength converter 1D. Therefore, in the wavelength converter 1D, it is conceived that optimization of manufacturing conditions thereof enable a reduction of the occurrence of the surface cracks.

Note that, in view of the shape, size and presence frequency of pitches and the like of the surface cracks, it is conceived that the surface cracks have a small function to scatter the visible light and have a large function to transmit/reflect the visible light. Therefore, it is conceived that, even if the surface cracks are present, the surface cracks do not give the wavelength converter 1D and the wavelength conversion member 100D such an influence bad enough to cancel the optical effect obtained in the present invention.

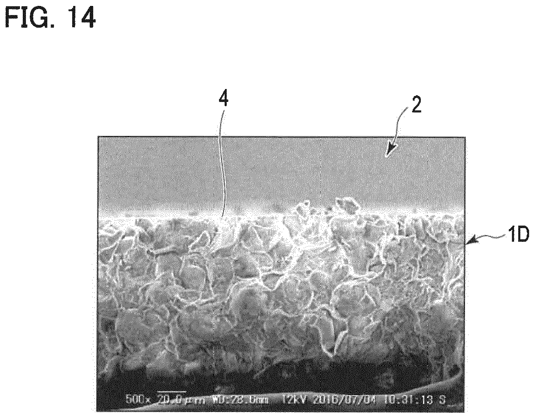

FIG. 14 is an example of a scanning electron microscope (SEM) picture showing the planar emission surface 2 on the cross section shown in FIG. 13. As shown in FIG. 14, the planar surface 4 is formed on the planar emission surface 2 of the wavelength converter 1D.

### <Functions of wavelength converter and wavelength conversion member according to fourth embodiment>

Functions of the wavelength converter 1D and the wavelength conversion member 100D are similar to the functions of the wavelength converter 1A and the wavelength conversion member 100A according to the first embodiment.

Moreover, since the planar emission surface 2 has the planar surface 4, for the wavelength converter 1D and the wavelength conversion member 100D, it is easy to enhance the absorption efficiency of the excitation light.

### <Effects of wavelength converter and wavelength conversion member according to fourth embodiment>

Effects of the wavelength converter 1D and the wavelength conversion member 100D are similar to the effects of the wavelength converter 1A and the wavelength conversion member 100A according to the first embodiment.

Moreover, since the planar emission surface 2 has the planar surface 4, for the wavelength converter 1D and the wavelength conversion member 100D, it is easy to enhance the absorption efficiency of the excitation light. Therefore, the wavelength conversion member 100D including the wavelength converter 1D are useful for the purpose of a projector or the like.

### [Modification Example]

As a modification example of the wavelength converter, a wavelength converter can be used, in which features of the respective wavelength converters 1A, 1B, 1C and 1D according to the first to fourth embodiments described above are combined with one another. Functions/effects of this modification example are a combination of the functions/effects based on the features of the respective wavelength converters.

Moreover, as a modification example of the wavelength conversion member, a wavelength conversion member can be used, which has a structure in which the features of the respective wavelength conversion members 100A, 100B, 100C and 100D according to the first to fourth embodiments described above are combined with one another. Functions/effects of this modification example are a combination of the functions/effects based on the features of the respective wavelength conversion members.

In each of the wavelength conversion members 100 (100A, 100B, 100C and 100D) according to the above-described first to fourth embodiments, the example where the single wavelength converter 1 (1A, 1B, 1C and 1D) is provided on the surface of the single substrate 80 is shown. However, as a modification example of the wavelength conversion member 100, a wavelength conversion member can be used, which has a structure in which two or more wavelength converters 1 are provided on the surface of the single substrate 80. In accordance with this modification example, a plurality of the wavelength converters 1 having different wavelength conversion characteristics can be formed on the surface of the single substrate 80.

### [Light Emitting Device]

When there are used the wavelength converter or the wavelength conversion member according to each of the first to fourth embodiments and an excitation source that irradiates the wavelength converter with appropriate excitation light, then a light emitting device that obtains white light is obtained. A known excitation source can be used as the excitation source.

### EXAMPLES

Hereinafter, this embodiment will be described more in detail by examples; however, this embodiment is not limited to these examples.

### [Example 1]

### (Preparation of mixed solution)

First, as phosphor particles, YAG particles (YAG462E205 produced by Nemoto Lumi-Materials Company Limited) having an average particle size D₅₀ of approximately 20.5 µm were prepared. Moreover, as nanoparticles, an aqueous solution (ALW10WT-G0 produced by CIK NanoTek Co., Ltd.) in which aluminum oxide nanoparticles having an average particle size D₅₀ of approximately 20 nm were dispersed was prepared. Next, the above-described YAG particles were added to the aqueous solution in which the above-described nanoparticles were dispersed, and an obtained mixture was kneaded, whereby a nanoparticle-mixed solution (nanoparticle-mixed solution No. 1) was prepared.

### (Application of nanoparticle-mixed solution)

A tape is mounted onto a metal substrate made of aluminum to form a step. The nanoparticle-mixed solution was dropped to a portion surrounded by the step, and the nanoparticle-mixed solution No. 1 was applied using an applicator equipped with a bar coater.

### (Formation of wavelength converter)

The metal substrate applied with the nanoparticle-mixed solution No. 1 was dried at a normal temperature. Then, a dried body having a film thickness of 100 µm was obtained. This dried body was formed as a wavelength converter (wavelength converter No. 1) including the YAG particles and a binder layer that was composed of the nanoparticle-adhered body in which the plurality of aluminum oxide nanoparticles were adhered to one another and adhered the adjacent YAG particles to one another by the nanoparticle-adhered body. In this way, a wavelength conversion member (wavelength conversion member No. 1) in which the film-like wavelength converter No. 1 having a thickness of 100 µm was formed on the metal substrate was obtained.

### (Evaluation)

### <Microscopy>

A fracture surface of the wavelength converter No. 1 was observed by a scanning electron microscope (SEM) and a transmission electron microscope (TEM). FIG. 4 is an example of a scanning electron microscope (SEM) picture of the fracture surface of the wavelength converter No. 1 according to Example 1. FIG. 5 is an example of a transmission electron microscope (TEM) picture of the portion B in FIG. 4. FIG. 6 is an example of a scanning electron microscope (SEM) picture of the phosphor particles which are the raw material of the wavelength converter No. 1 according to Example 1.

As shown in FIG. 4, the binder layer 20 is formed on the surfaces of the YAG particles (phosphor particles) 10 and between the YAG particles 10, and the adjacent YAG particles 10 are adhered to one another by the binder layer 20, whereby the wavelength converter 1 (wavelength converter No. 1) is formed. The binder layer 20 is composed of the nanoparticle-adhered body in which the plurality of nanoparticles made of aluminum oxide are adhered to one another.

FIG. 6 shows a SEM picture of the YAG particles 10 on and between which the binder layer 20 is not formed. FIG. 6 shows the YAG particles used to be mixed with the aqueous solution in which the nanoparticles are dispersed. As shown in FIG. 6, in the YAG particles 10 on and between which the binder layer 20 is not formed, the gaps 15 are formed between the adjacent YAG particles 10, and the adjacent YAG particles 10 are not adhered to one another.

As shown in FIG. 4, in the wavelength converter 1 (wavelength converter No. 1), the surfaces of the individual YAG particles 10 shown in FIG. 6 are covered with the binder layer 20 composed of the nanoparticle-adhered body made of aluminum oxide, and in addition, the binder layer 20 described above is interposed between the YAG particles 10. However, the portions between the adjacent YAG particles 10 are not completely filled with the binder layer 20 without any clearance, and the gaps 25 are partially formed in the binder layer 20.

FIG. 5 is an example of the transmission electron microscope (TEM) picture of the portion B of the binder layer 20 in FIG 4. FIG. 5 is a picture showing the enlarged and observed portion B in FIG. 4. As shown in FIG. 5, the binder layer 20 is composed of the nanoparticle-adhered body in which the plurality of nanoparticles 21 made of aluminum oxide are adhered to one another. Moreover, from FIG. 5, it is seen that the nanogaps 27 having a diameter of approximately 15 nm and 5 nm are formed in the binder layer 20 composed of the nanoparticle-adhered body. It is conceived that these nanogaps 27 are gaps which have remained between the nanoparticles 21 when the plurality of nanoparticles 21 are adhered to one another to form the binder layer 20 composed of the nanoparticle-adhered body.

### <Evaluation of nanogaps of binder layer>

A pore size of the nanogaps 27 of the wavelength converter No. 1 was measured. The pore size of the nanogaps 27 was measured by a nitrogen adsorption method using Autosorb (registered trademark)-3 made by Quantachrome Instruments Co., Ltd. Results are shown in FIG. 7. From FIG 7, it is seen that the nanogaps 27 having a pore size of approximately 100 Å (10 nm) are present in an inside of the wavelength converter No. 1.

### <Test of irradiating wavelength converter with laser beam>

The wavelength conversion member No. 1 was pasted onto a metal-made heat sink. Then, a laser beam having a center wavelength λ of 450 nm was applied to the wavelength converter No. 1 from a front surface side thereof. A temperature of a surface of the wavelength converter was measured by a thermal viewer. Power of the laser light source was set to 3.5 W, an incident angle of the laser light was set to 45°, and an application time of the laser beam was set to 60 seconds. Table 1 shows measurement results of the temperatures of the surfaces of the wavelength converters.

**[Table 1]**

| | Wavelength Converter | | Evaluation | Remarks |
|---|---|---|---|---|
| | Film Thickness (µm) | Component of Binder Layer | Surface Temperature of Wavelength Converter (°C) | |
| Example 1 | 100 | Alumina Nanoparticle | 39 | |
| Comparative example 1 | 100 | Silicon | - | Binder layer is burnt |

### [Example 2]

A wavelength conversion member (wavelength conversion member No. 2) was obtained in a similar way to Example 1 except that a nanoparticle-mixed solution (nanoparticle-mixed solution No. 2) in which a solid content concentration of nanoparticles made of aluminum oxide was 1.3 times that of the nanoparticle-mixed solution of Example 1 was used in place of the nanoparticle-mixed solution No. 1.

### [Example 3]

To the nanoparticle-mixed solution No. 1 obtained in Example 1, boron nitride particles (SHOBN made by Showa Denko K.K.) having an average particle size D₅₀ of approximately 10 µm were added in a ratio of 5 parts by mass with respect to 100 parts by mass of the YAG particles, and an obtained mixture was kneaded, whereby a nanoparticle-mixed solution No. 3 was obtained. A wavelength conversion member (wavelength conversion member No. 3) was obtained in a similar way to Example 1 except that the nanoparticle-mixed solution No. 3 was used in place of the nanoparticle-mixed solution No. 1.

### [Example 4]

A bending stress was applied by a tool to the metal substrate of the wavelength conversion member No. 1 obtained in Example 1, whereby the metal substrate and the wavelength converter No. 1 were peeled off from each other on purpose. Front and back surfaces of the peeled wavelength converter No. 1 were inverted, and the wavelength converter No. 1 and the metal substrate are adhered again to each other so that the peeled surface of the wavelength converter No. 1 becomes a new surface (planar emission surface) remote from the metal substrate. In this way, a wavelength conversion member (wavelength conversion member No. 4) including the metal substrate and the wavelength converter No. 4 was obtained.

For the obtained wavelength conversion member No. 4, a surface shape of the wavelength converter No. 4 was analyzed.

### <Surface shape analysis>

The surface of the wavelength converter No. 4 was subjected to step measurement ten times by a probe-type step profiler (DEKTAK made by Bruker Corporation) at a scanning distance of 2 mm. In this way, it is seen that two regions are present on the surface of the wavelength converter 4, the two regions being: a planar surface having surface roughness of Ra ≤ 0.15 µm and Rz ≤ 0.3 µm; and a recessed portion having a groove width of 10 mm or more and a depth of 1 mm or more. Note that, for Ra, such 2-mm scanning was carried out ten times, and an average value of ten measurement values of a ratio of the planar surface in uniaxial data was taken as Ra.

### [Comparative example 1]

A wavelength conversion member in which a film-like wavelength converter having a thickness of 100 µm was formed on a metal substrate was obtained in a similar way to Example 1 except that silicon resin (two-part type RTV silicon rubber KE106 made by Shin-Etsu Chemical Co., Ltd.) was used in place of the nanoparticle-mixed solution. A wavelength converter of this wavelength conversion member included: YAG particles; and a binder layer that was made of the silicon resin and adhered the YAG particles to one another by the silicon resin.

In a similar way to Example 1, such a laser beam application test was carried out using the obtained wavelength converter. Note that the binder layer was burnt during the laser beam application test. Results are shown in Table 1. From Table 1, it is seen that the wavelength converter of Example 1 has higher heat dissipation and heat dissipation than the wavelength converter of Comparative example 1.

### [Example 5] <Fabrication of wavelength converter using mixed solution containing ZnO sol-gel solution and ZnO nanoparticles>

### (Preparation of mixed solution)

First, YAG phosphor powder in which an average particle size D₅₀ was approximately 20 µm was prepared. Note that the YAG phosphor powder was synthesized by an orthodox solid phase reaction. Moreover, zinc acetate dihydrate was dispersed into methanol, whereby a sol-gel solution containing 10% by mass of zinc acetate was obtained. Thereafter, 1.0 g of the YAG phosphor powder, 0.5 g of the sol-gel solution and 0.5 g of a suspension in which 30% by mass of zinc oxide nanoparticles having an average particle size of 20 nm was dispersed were mixed with one another, whereby a mixed solution (mixed solution No. 5) was obtained.

### (Fabrication of inorganic wavelength converter)

A plurality of metal substrates, each of which was composed of an aluminum alloy and had a length of 20 mm, a width of 20 mm and a thickness of 0.5 mm, were continuously arrayed, a Kapton tape (thickness: 0.1 mm) was pasted onto a peripheral portion of each of the metal substrates, and a step was provided on each of the metal substrates. The mixed solution No. 5 was dropped to a portion of each of the metal substrates, which was surrounded by the step, whereby a wavelength converter was fabricated. Specifically, to the portion surrounded by the step, the mixed solution No. 5 was applied by bar coating using an applicator, and a solvent was dried at 100°C for 1 hour by a hot plate, thereafter, a dried substance was heated at 350°C for 5 hours using a drying oven. In this way, a wavelength conversion member (wavelength conversion member No. 5) in which an inorganic wavelength converter (wavelength converter No. 5) was formed on the metal substrate was obtained. A thickness of the wavelength converter No. 5 was the same as the thickness of the Kapton tape. An average particle size of the nanoparticles which composed the binder layer that joined the phosphor particle 10 to one another was 10 to 20 nm.

With regard to the wavelength converter No. 5 that composed the obtained wavelength conversion member No. 5, a fracture surface of the wavelength converter No. 5 was observed by the scanning electron microscope (SEM) in a similar way to Example 1. On the fracture surface of the wavelength converter No. 5, a small number of the internal cracks 46 as shown in FIG. 9 were observed.

### [Example 6] <Fabrication of wavelength converter using ZnO sol-gel solution that does not contain nanoparticles>

### (Preparation of mixed solution)

First, YAG phosphor powder in which an average particle size D₅₀ was approximately 20 µm was prepared. Note that the YAG phosphor powder was synthesized by an orthodox solid phase reaction. Moreover, zinc acetate dihydrate was dispersed into methanol, whereby a sol-gel solution containing 10% by mass of zinc acetate was obtained. Thereafter, 1.0 g of the above-described YAG phosphor powder and 0.5 g of the above-described sol-gel solution were mixed with each other, whereby a mixed solution (mixed solution No. 6) was obtained.

### (Fabrication of inorganic wavelength converter)

A plurality of metal substrates, each of which was composed of an aluminum alloy and had a length of 20 mm, a width of 20 mm and a thickness of 0.5 mm, were continuously arrayed, a Kapton tape (thickness: 0.1 mm) was pasted onto a peripheral portion of each of the metal substrates, and a step was provided on each of the metal substrates. The mixed solution No. 6 was dropped to a portion of each of the metal substrates, which was surrounded by the step, whereby a wavelength converter was fabricated. Specifically, to the portion surrounded by the step, the mixed solution No. 6 was applied by bar coating using an applicator, and a solvent was dried at 100°C for 1 hour by a hot plate, thereafter, a dried substance was heated at 350°C for 5 hours using a drying oven. In this way, a wavelength conversion member (wavelength conversion member No. 6) in which an inorganic wavelength converter (wavelength converter No. 6) was formed on the metal substrate was obtained. A thickness of the wavelength converter No. 6 was the same as the thickness of the Kapton tape. An average particle size of the nanoparticles which composed the binder layer that joined the phosphor particle 10 to one another was less than 10 nm.

With regard to the wavelength converter No. 6 that composed the obtained wavelength conversion member No. 6, a fracture surface of the wavelength converter No. 6 was observed by the scanning electron microscope (SEM) in a similar way to Example 1. On the fracture surface of the wavelength converter No. 6, a large number of the internal cracks 46 as shown in FIG. 9 were observed.

### (Comparison between Example 5 and Example 6)

By the SEM microscopy, it is seen that an amount of the caused internal cracks was smaller in the wavelength converter No. 5 of Example 5 than in the wavelength converter No. 6 of Example 6. Note that the particle size of the nanoparticles which compose the binder layer that joins the phosphor particles 10 to one another is smaller in the wavelength converter No. 6 of Example 6 than in the wavelength converter No. 5 of Example 5. Therefore, it is conceived that many internal cracks occur when the size of the particles which compose the binder layer that joins the phosphor particles 10 to one another is too small.

It is conceived that the internal cracks are generated by an internal stress caused while the wavelength converter is dried and baked when the wavelength converter is fabricated from the mixed solution as a raw material. Therefore, it is conceived that the occurrence of the internal cracks is increased since an amount of the gaps between the phosphor particles 10 decreases if the particle size of the nanoparticles which compose the binder layer is too small.

It is seen that the occurrence of the internal cracks is reduced in such a manner that the average particle size of the nanoparticles which compose the binder layer that holds the phosphor is set to 10 nm or more as described above.

The entire contents of Japanese Patent Application No. 2015-242020 (filed on: December 11, 2015) is incorporated herein by reference.

Although the contents of this embodiment have been described above in accordance with the examples, it is obvious to those skilled in the art that this embodiment is not limited to the description of these and that various modifications and improvements are possible.

### INDUSTRIAL APPLICABILITY

Even when irradiated with the high-power excitation light, the wavelength converter, wavelength conversion member and light emitting device of the present invention are excellent in heat resistance and heat dissipation, and are excellent in productivity.

### REFERENCE SIGNS LIST

1, 1A, 1B, 1C, 1D WAVELENGTH CONVERTER
2 PLANAR EMISSION SURFACE
3 IRREGULAR SURFACE
4 PLANAR SURFACE
10 PHOSPHOR PARTICLE (YAG PARTICLE)
15 GAP
20 BINDER LAYER
21 NANOPARTICLE
23 NANOPARTICLE-ADHERED BODY
25 GAP
27 NANOGAP (MINUTE GAP)
30 NANOPARTICLE-COVERED PHOSPHOR PARTICLE
40 PHOSPHOR PARTICLE-SURROUNDED REGION
44 SOLID PORTION
45 BINDER PORE
46 CRACK
50 HIGH HEAT DISSIPATION PORTION
80 SUBSTRATE
100, 100A, 100B, 100C, 100D WAVELENGTH CONVERSION MEMBER

## Claims

1. A wavelength converter comprising:
a plurality of phosphor particles; and
a binder layer that adheres the plurality of adjacent phosphor particles to one another, the binder layer being composed of a nanoparticle-adhered body in which a plurality of nanoparticles having an average particle size D₅₀ of 1 nm or more and less than 100 nm are adhered to one another.

2. The wavelength converter according to claim 1, wherein the average particle size D₅₀ of the nanoparticles is 10 nm or more and less than 100 nm.

3. The wavelength converter according to either one of claims 1 and 2, wherein the phosphor particles include phosphor particles in which a luminance maintenance rate is 80% or less, the luminance maintenance rate being obtained by dividing a luminance of the phosphor particles, which are already burnt at 1200°C or more in an atmosphere, by a luminance of the phosphor particles, which are not still burnt at 1200°C or more in the atmosphere.

4. The wavelength converter according to any one of claims 1 to 3, wherein the binder layer includes nanogaps which are gaps having a pore size of less than 0.3 µm in an inside.

5. The wavelength converter according to any one of claims 1 to 4, wherein at least some parts of phosphor particle-surrounded regions surrounded by the phosphor particles adhered to one another via the binder layer do not include binder pores, the binder pores being gaps having a pore size of 0.3 µm or more in the binder layer.

6. The wavelength converter according to any one of claims 1 to 5, wherein the wavelength converter includes the binder pores in a ratio of 39% by volume or less.

7. The wavelength converter according to any one of claims 1 to 6, further comprising high heat dissipation portions having a particle size of 1 µm or more and made of a material in which thermal conductivity at 25°C is higher than thermal conductivity of the nanoparticles at 25°C, each of the high heat dissipation portions being provided between adjacent portions of the binder layer.

8. The wavelength converter according to claim 7, wherein the thermal conductivity of the high heat dissipation portions at 25°C is 10 W/m·K or more.

9. The wavelength converter according to either one of claims 7 and 8, wherein each of the high heat dissipation portions is interposed between the portion of the binder layer, the portion being formed on the phosphor particle on one side, and the portion of the binder layer, the portion being formed on the phosphor particle on other side.

10. The wavelength converter according to any one of claims 1 to 9, wherein the wavelength converter has a planar emission surface on a surface of the wavelength converter itself, and at least a part of the planar emission surface is a planar surface that satisfies Ra ≤ 0.15 µm and Rz ≤ 0.3 µm.

11. The wavelength converter according to claim 10, wherein occupancy of the planar surface with respect to an area of the planar emission surface is 36% or more and 65.5% or less.

12. A wavelength conversion member comprising:
a substrate; and
the wavelength converter according to any one of claims 1 to 11 formed on the substrate.

13. The wavelength conversion member according to claim 12, wherein the wavelength converter that is single is provided on a surface of the substrate that is single.

14. A light emitting device, wherein the light emitting device obtains white light by using the wavelength converter according to any one of claims 1 to 11 or the wavelength conversion member according to either one of claims 12 and 13.
